## Europäisches Patentamt

(19) **European Patent Office**

**Office européen des brevets**

(11) Veröffentlichungsnummer: **0 120 373**
**B1**

(12) **EUROPÄISCHE PATENTSCHRIFT**

(45) Veröffentlichungstag der Patentschrift:
04.06.86

(21) Anmeldenummer: 84102544.8

(22) Anmeldetag: 09.03.84

(51) Int. Cl.⁴: **C 23 C 16/26,** B 22 C 3/00,
B 22 D 11/07

(54) **Verfahren zum Beschichten von Oberflächen mit Russ.**

(30) Priorität: 24.03.83 DE 3310758

(43) Veröffentlichungstag der Anmeldung:
03.10.84 Patentblatt 84/40

(45) Bekanntmachung des Hinweises auf die Patenterteilung:
04.06.86 Patentblatt 86/23

(84) Benannte Vertragsstaaten:
BE CH DE FR IT LI NL

(56) Entgegenhaltungen:
CH - A - 606 449
GB - A - 1 564 926
GB - A - 2 018 299

PATENT ABSTRACTS OF JAPAN, unexamined
applications, C Field, Vol. 6, No. 31, February 24, 1982
THE PATENT OFFICE JAPANESE GOVERNMENT Seite
132 C 92

(73) Patentinhaber: **Linde Aktiengesellschaft,**
**Abraham-Lincoln-Strasse 21, D-6200 Wiesbaden (DE)**

(72) Erfinder: **Meinass, Helmut, Dipl.-Ing.,**
**Dompfaffenweg 12i, D-8192 Geretsried (DE)**

(74) Vertreter: **Schaefer, Gerhard, Dr., Linde**
**Aktiengesellschaft Zentrale Patentabteilung,**
**D-8023 Höllriegelskreuth (DE)**

# Beschreibung

Die Erfindung betrifft ein Verfahren zum Beschichten von Oberflächen mit Russ, bei dem ein organisches brennbares Gas verbrannt und die Verbrennungsflamme auf die zu beschichtende Oberfläche gerichtet wird.

Aus der Giesstechnik ist es beispielsweise bekannt, Kokillen vor dem Giessvorgang mit Russ zu beschichten. Durch die Russschicht wird die Kokille gegen thermische Beschädigungen durch das flüssige Metall, z.B. flüssiges Eisen, geschützt. Zu diesem Zweck wird Russ durch thermische Zersetzung von Acetylen erzeugt. Acetylen eignet sich wegen der hohen Russausbeute besonders als organisches brennbares Gas. Das Acetylen wird aus Flaschen, die mit einer porösen Masse und einem Lösungsmittel gefüllt sind, entnommen, einem Berussungsbrenner zugeführt und verbrannt. Die Gasflamme, aus der Russpartikel und die bei der Verbrennung gebildeten Reaktionsgase austreten, wird gegen die zu beschichtende Oberfläche gerichtet. Beim Auftreffen der Russpartikel auf die Oberfläche bleiben diese wenigstens zum Teil haften und bilden im Verlauf des Beschichtungsvorganges eine Russschicht.

Russschichten, die nach diesem Verfahren hergestellt werden, besitzen jedoch eine unbefriedigende Qualität. Es ist festgestellt worden, dass derartige Russschichten ungleichmässig sind und sich leicht von der Oberfläche, auf der die Russschicht haftet, lösen. Dieser Effekt tritt beispielsweise beim Eingiessen einer Schmelze in eine Kokille, die nach dem bekannten Verfahren mit Russ beschichtet wurde, ein.

Der Erfindung liegt daher die Aufgabe zugrunde, ein Verfahren der eingangs geschilderten Art anzugeben, durch das Russschichten guter Qualität, insbesondere Russschichten mit grosser Haftfestigkeit gebildet werden.

Diese Aufgabe wird erfindungsgemäss dadurch gelöst, dass dem Gas vor der Verbrennung ein Treibgas zugemischt und/oder die Verbrennungsflamme wenigstens teilweise von einem Hüllgasstrahl umgeben wird.

Erfindungsgemäss gibt es zwei Alternativen: In der einen Variante wird ein Brenngasstrom hergestellt, in dem dem organischen Gas vor der Verbrennung ein Treibgas zugemischt wird. In der anderen Variante wird die Verbrennungsflamme wenigstens teilweise von einem Hüllgasstrahl umgeben, der die Flamme in Richtung auf die zu beschichtende Oberfläche beschleunigt.

In beiden Fällen ist die Berussungsflamme im Vergleich zu herkömmlichen Verfahren „härter", d.h. bei unverändertem Gasdurchsatz ist die Geschwindigkeit der Flammengase und der Russpartikel höher.

Durch die erfindungsgemässe Massnahme wird nun erreicht, dass im Vergleich zum konventionellen Verfahren die Haftfestigkeit des Russes auf der zu beschichtenden Oberfläche erhöht, die Beschichtung dichter und Vertiefungen in der zu beschichtenden Oberfläche besser beschichtet werden. Es ist beim Eingiessen von Schmelzen in eine mit Russ beschichtete Kokille festgestellt worden, dass die Gefahr des Ablösens einer nach dem erfindungsgemässen Verfahren hergestellten Russschicht erheblich geringer ist.

Weiterhin konnte festgestellt werden, dass beim erfindungsgemässen Verfahren im Vergleich zum bekannten Verfahren mehr Russpartikel auf die zu beschichtende Oberfläche gelangen, so dass die Verluste an Russ geringer sind.

Wird dem organischen Gas vor dem Verbrennen ein Treibgas zugemischt, so wird die Flamme härter, da durch das Treibgas die Flammenlänge vergrössert wird. Dabei wird die Bildung von Russ verzögert. Das Treibgas wirkt zusätzlich beschleunigend auf die Russpartikel.

Durch die andere Variante wird ebenfalls die Strahlwirkung erhöht. Da jedoch Brenngasstrahl und Hüllgasstrahl getrennt sind, wird die Russbildung nicht oder nur in geringem Mass verzögert.

Die Beschleunigung der Flammengase wird nach bevorzugten Ausgestaltungen der Erfindung auf folgende Weise erzielt.

Einerseits besitzt der Hüllgasstrahl eine höhere Strömungsgeschwindigkeit als das Brenngas bzw. die bei der Verbrennung gebildeten Flammengase. Durch Gasreibung wird die Geschwindigkeit der Flammengase gesteigert. Andererseits wird das Hüllgas so gegen die Flammengase gelenkt, dass das Hüllgas eine Geschwindigkeitskomponente in Richtung senkrecht zu der Strömungsrichtung der Flammengase im Randbereich der Flamme besitzt. Auf diese Weise wird der Strömungsquerschnitt der Flammengase verringert. Diese Einschnürung führt zu einer Erhöhung der Strömungsgeschwindigkeit der Flammengase.

Ein Vorteil des erfindungsgemässen Verfahrens ist, dass nach anfänglich niedriger Flammengeschwindigkeit Russ bei hoher Flammengeschwindigkeit gebildet wird, der so mit hoher Geschwindigkeit auf die zu beschichtende Oberfläche geblasen wird.

Eine besonders hohe Haftfestigkeit der Russschicht, besonders geringe Russverluste sowie besonders gleichmässige und dichte Russschichten ergeben sich vorteilhafterweise dann, wenn die beiden erfindungsgemässen Varianten kombiniert werden, d.h. wenn dem Gas vor der Verbrennung ein Treibgas zugemischt und die Verbrennungsflamme wenigstens teilweise von einem Hüllgasstrahl umgeben wird.

In einer vorteilhaften Ausgestaltung der Erfindung ist das Treibgas ein inertes Gas, insbesondere Kohlendioxid oder Stickstoff. Hierbei wird unter einem inerten Gas ein völlig reaktionspassives Gas verstanden.

Die Qualität der Russschicht ist besonders gut, wenn nach einer weiteren vorteilhaften Ausgestaltung der Erfindung das Treibgas dem organischen Gas in einer Menge zugemischt wird, die einen Treibgasanteil am Gasgemisch von 2 Mol-% bis 12 Mol-% und insbesondere einen Treibgasanteil am Gasgemisch von 3 Mol-% bis 7 Mol-% ergibt.

Nach einem weiteren Merkmal der Erfindung ist das Hüllgas ein inertes Gas, insbesondere Kohlendioxid oder Stickstoff. Hierbei wird unter einem inerten Gas ebenfalls ein Gas verstanden, das sich völlig reaktionspassiv verhält. Auch an den Flammenaussenseiten kommt es daher zu keinen Reaktionen zwischen Hüllgas und Flammengasen, wodurch die Russausbeute verbessert wird.

In einer Variante der Erfindung, durch die vorteilhafterweise die Korngrösse der Russpartikel verkleinert und die flüchtigen Bestandteile im Russ verringert werden können, wird dem Brenngas ein ungebundenen Sauerstoff enthaltendes Gas wie Luft, mit Sauerstoff angereicherte Luft oder reiner Sauerstoff zugemischt. Wird dem Brenngas kein sauerstoffhaltiges Gas zugemischt, so enthält der gebildete Russ flüchtige Bestandteile, die bei Wärmezufuhr Gase bilden. Ausserdem neigt auf diese Weise hergestellter Russ dazu, zu verkoken. Beide Effekte führen z.B. beim Giessen von Metallen zu Gussfehlern. Andererseits führt die Zumischung eines sauerstoffhaltigen Gases dazu, dass gebildeter Russ eine geringere Haftfestigkeit besitzt. Da durch das erfindungsgemässe Verfahren die Haftfestigkeit des Russes erhöht wird, kann dem organischen Gas beim erfindungsgemässen Verfahren ein ungebundenen Sauerstoff enthaltendes Gas zugemischt werden, denn die auf den Gehalt an Sauerstoff zurückzuführende Minderung der Russ-Haftfestigkeit ist schwächer als die durch das erfindungsgemässe Verfahren zu erzielende Erhöhung der Russ-Haftfestigkeit.

Die besten Resultate werden in einer weiteren Ausgestaltung des erfindungsgemässen Verfahrens erzielt, wenn der Sauerstoffanteil im Gemisch aus Brenngas und dem den ungebundenen Sauerstoff enthaltenden Gas 1 bis 5 Mol-% beträgt.

Ein zur Durchführung des Verfahrens besonders geeignetes Brennersystem besteht im wesentlichen aus einem Brenngasrohr mit Austrittsöffnungen sowie zwei dem Brenngasrohr benachbarten Hüllgasrohren mit zugehörigen Austrittsöffnungen, wobei die Rohrachsen der Hüllgasrohre in einer Ebene mit der Achse des Brenngasrohres liegen.

Mit diesem Brennersystem können besonders gleichmässige Russschichten erzielt werden. Insbesondere ist es möglich, die Länge der Rohre z.B. auf die Länge einer Seite der zu beschichtenden Oberfläche abzustimmen und das Brennersystem entlang der anderen Seite der Oberfläche zu bewegen. Oberflächen können dadurch rasch und auf wirtschaftliche Weise berusst werden.

In einer bevorzugten Ausgestaltung eines erfindungsgemässen Brennersystems sind die Austrittsöffnungen des Brennergasrohres im wesentlichen senkrecht zu der Ebene orientiert, in der die Rohrachsen des Brenngasrohres und der Hüllgasrohre liegen. Die Austrittsöffnungen der Hüllgasrohre und die Austrittsöffnungen des Brenngasrohres können so zueinander orientiert sein, dass aus diesen Rohren austretende Gasströme parallel zueinander strömen oder konvergieren, so dass der Strömungsquerschnitt der Flammengase eingeschnürt und deren Strömungsgeschwindigkeit erhöht wird.

Auf diese Weise kann die Verbrennungsflamme optimal vom Hüllgasstrom umgeben werden.

Besonders günstige Resultate werden erzielt, wenn die Austrittsöffnungen des Brenngasrohres in zwei Reihen angeordnet sind, die parallel zur Rohrachse verlaufen und diametral gegenüberliegen und wenn die Austrittsöffnungen der Hüllgasrohre die Form eines parallel zur Rohrachse verlaufenden Schlitzes besitzen. Die Schlitzbreite kann hierbei z.B. durch Abdeckungen verändert werden.

Im folgenden soll ein Ausführungsbeispiel des erfindungsgemässen Verfahrens und eines erfindungsgemässen Brennersystems anhand schematischer Skizzen erläutert werden.

Es zeigen:

Figur 1 einen Längsschnitt durch eine zum Berussen geöffnete Kokille sowie durch einen erfindungsgemässen Berussungsbrenner;

Figur 2 einen Querschnitt durch einen Berussungsbrenner;

Figur 3 einen Querschnitt durch eine zum Berussen geöffnete Kokille sowie durch einen erfindungsgemässen Berussungsbrenner.

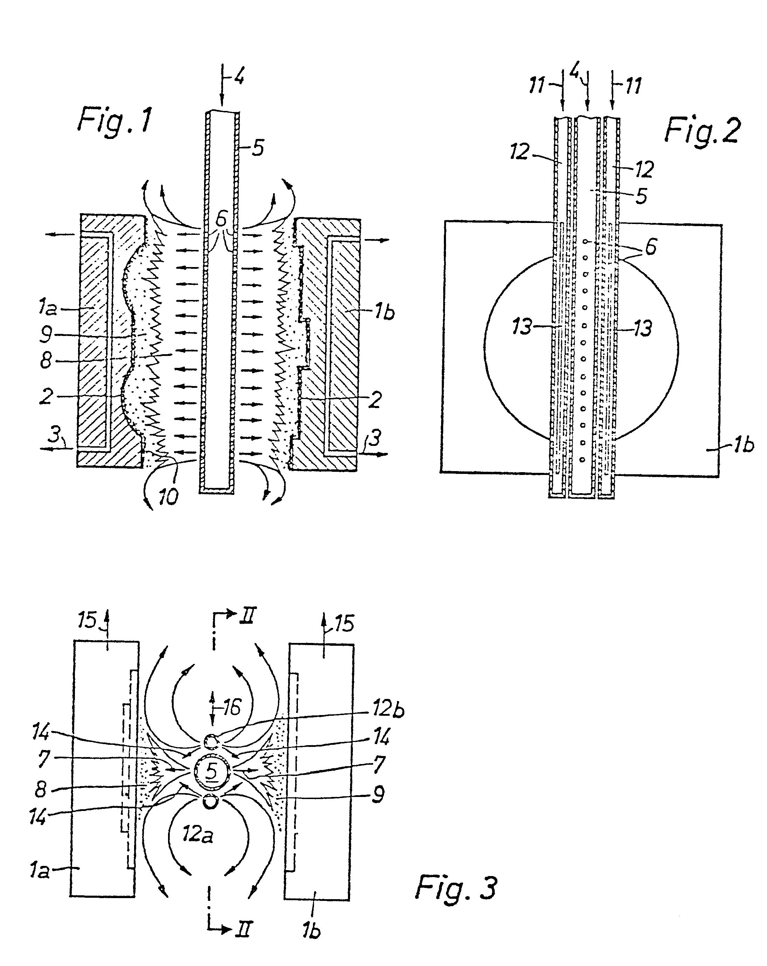

In allen Figuren sind identische Bauteile mit den gleichen Bezugsziffern versehen. In Figur 1 ist eine aus zwei Hälften 1a und 1b bestehende Kokille dargestellt. Die Kokille ist geöffnet, d.h. die beiden Kokillenhälften sind mit Abstand zueinander angeordnet, so dass ein Berussungsbrenner zwischen die beiden Kokillenhälften eingeführt werden kann. In diesem Längsschnitt ist die Gussform 2 im Profil zu erkennen. Ausserdem sind Kühlwasserkanäle 3 dargestellt.

Der Berussungsbrenner selbst (siehe auch Figuren 2 und 3) besteht aus einem zentralen Brennerrohr 5, in dessen Wand sich diametral gegenüberliegend jeweils eine Reihe von Brenner-Austrittsöffnungen 6 befinden. Parallel zum Brennerrohr 5 sind an gegenüberliegenden Seiten des Brennerrohres 2 Hüllgasrohre 12a, 12b angeordnet. Die Achsen des Brennerrohres 5 und der Hüllgasrohre 12a, 12b liegen somit in einer Ebene.

Während des Berussens wird der Berussungsbrenner so orientiert, dass diese Ebene im wesentlichen parallel zu den zu berussenden Oberflächen der beiden Kokillenhälften 1a und 1b verläuft. In beiden Hüllgasrohren 12a, 12b sind jeweils zwei schlitzförmige Austrittsöffnungen 13 so angeordnet, dass austretendes Hüllgas (dargestellt durch Pfeile 14) und das aus dem Brennerrohr 5 austretende Brenngas (dargestellt durch Pfeile 7) im wesentlichen parallel oder konvergierend strömen, so dass der Strömungsquerschnitt der Flammengase eingeschnürt wird.

Ein organisches Gas, im Ausführungsbeispiel Acetylen, wird über eine Brenngaseinspeisung 4 in das Brennerrohr 5 eingeleitet. Das aus den Brenner-Austrittsöffnungen 6 ausströmende Acetylen entzündet sich und bildet Berussungsflammen 8, die auf die Kokillenhälften 1a und 1b gerichtet sind. Bei der Verbrennung des Acetylens bilden sich Russ und Flammengase 9 (bei Acetylen als organischem Gas bildet sich als Reaktionsgas im wesentlichen Wasserstoff). Sowohl Flammengase als auch Russpartikel 9 bewegen sich auf die jeweilige Kokillenhälfte zu, wobei die Russpartikel nach Auftreffen auf der Kokillenoberfläche an dieser bzw. an bereits haftenden Russpartikeln haften bleiben. An der Kokillenoberfläche bildet sich auf diese Weise eine Russschicht 10.

Treibgas, im Ausführungsbeispiel Stickstoff, wird dem Acetylen vor Eintritt in das Brennerrohr zugemischt. Das auf diese Weise gebildete Brenngas wird in einer Menge von etwa 4 m³/h dem Brennerrohr zugeführt. Hüllgas, im Ausführungsbeispiel Luft in einer Menge von 8 bis 12 m³/h, wird in die beiden Hüllgasrohre 12a und 12b über je eine Hüllgaseinspeisung 11 eingeleitet.

Während des Berussens kann entweder das Brennersystem 5, 12 relativ zu den ruhenden Kokillenhälften 1a, 1b oder diese relativ zum ruhenden Brennersystem bewegt werden (siehe Bewegungspfeile 15 bzw. 16). Die Relativgeschwindigkeit liegt in der Grössenordnung von 0,1 m/sec, beispielsweise 0,2 m/sec.

Für den Fall, dass die Kokillenhälften ruhen, hat es sich als besonders zweckmässig erwiesen, die Rohrachsen des Brennersystems horizontal anzuordnen und das Brennersystem in vertikaler Richtung zu bewegen. Aufgrund der Thermik sowie der Gasströmung, die durch die oberhalb der Kokillenhälften angeordnete Gasabsaugevorrichtung verursacht wird, werden die Flammengase nach oben abgelenkt. Daher ist es von Vorteil, dem oberhalb des Brennerrohres 5 angeordneten Hüllgasrohr 12b eine grössere Hüllgasmenge zuzuführen als dem unterhalb des Brennerrohres 5 angeordneten Hüllgasrohr 12a.

Falls erforderlich, kann das Brennerrohr beispielsweise mit Wasser gekühlt werden. Die dazu notwendigen Kühlschlangen können auf der Innenseite des Brennerrohres verlaufen.

**Patentansprüche**

1. Verfahren zum Beschichten von Oberflächen mit Russ, bei dem ein organisches, brennbares Gas verbrannt und die Verbrennungsflamme auf die zu beschichtende Oberfläche gerichtet wird, dadurch gekennzeichnet, dass dem Gas vor der Verbrennung ein Treibgas zugemischt und/oder die Verbrennungsflamme wenigstens teilweise von einem Hüllgasstrahl umgeben wird.

2. Verfahren nach Anspruch 1, dadurch gekennzeichnet, dass das Treibgas ein inertes Gas ist.

3. Verfahren nach Anspruch 2, dadurch gekennzeichnet, dass das inerte Gas Kohlendioxid oder Stickstoff ist.

4. Verfahren nach einem der Ansprüche 1 bis 3, dadurch gekennzeichnet, dass das Treibgas dem Brenngas in einer Menge zugemischt wird, die einen Treibgasanteil am Gasgemisch von 2 Mol-% bis 12 Mol-%, insbesondere 3 Mol-% bis 7 Mol-%, ergibt.

5. Verfahren nach einem der Ansprüche 1 bis 4, dadurch gekennzeichnet, dass das Hüllgas ein Inertgas oder Luft ist.

6. Verfahren nach Anspruch 5, dadurch gekennzeichnet, dass das Hüllgas Kohlendioxid oder Stickstoff ist.

7. Verfahren nach einem der Ansprüche 1 bis 6, dadurch gekennzeichnet, dass der Hüllgasstrahl eine höhere Strömungsgeschwindigkeit besitzt als das Brenngas bzw. die bei der Verbrennung gebildeten Flammengase.

8. Verfahren nach einem der Ansprüche 1 bis 7, dadurch gekennzeichnet, dass der Hüllgasstrahl die Verbrennungsflamme derart umgibt, dass der Strömungsquerschnitt der Flammengase eingeschnürt wird.

9. Verfahren nach einem der Ansprüche 1 bis 8, dadurch gekennzeichnet, dass dem Brenngas zusätzlich ein ungebundenen Sauerstoff enthaltendes Gas wie Luft, mit Sauerstoff angereicherte Luft oder reiner Sauerstoff zugemischt wird.

10. Verfahren nach Anspruch 9, dadurch gekennzeichnet, dass der Sauerstoffanteil im Gemisch aus Brenngas und dem den ungebundenen Sauerstoff enthaltenden Gas 1 bis 5 Mol-% beträgt.

11. Brennersystem zur Durchführung des Verfahrens nach einem der Ansprüche 1 bis 10, gekennzeichnet durch ein Brenngasrohr (5) mit Austrittsöffnungen (6), durch zwei dem Brenngasrohr (5) benachbarte Hüllgasrohre (12a, 12b) mit zugehörigen Austrittsöffnungen (13), wobei die Rohrachsen der Hüllgasrohre (12a, 12b) in einer Ebene mit der Achse des Brenngasrohres liegen.

12. Brennersystem nach Anspruch 11, dadurch gekennzeichnet, dass die Austrittsöffnungen des Brenngasrohres im wesentlichen senkrecht zu der durch die Rohrachsen aufgespannten Ebene orientiert sind.

13. Brennersystem nach Anspruch 12, dadurch gekennzeichnet, dass die Austrittsöffnungen in zwei Reihen angeordnet sind, die parallel zur Rohrachse verlaufen und diametral gegenüberliegen.

14. Brennersystem nach Anspruch 11, dadurch gekennzeichnet, dass die Austrittsöffnungen der Hüllgasrohre (12a, 12b) die Form eines parallel zur Rohrachse verlaufenden Schlitzes (13) besitzen.

**Revendications**

1. Procédé pour former un revêtement de noir de carbone sur des surfaces, selon lequel un gaz combustible organique est brûlé et la flamme de combustion est dirigée sur la surface à revêtir, caractérisé en ce qu'un gaz de propulsion est mélangé au gaz avant la combustion et/ou la flamme de combustion est entourée au moins partiellement par un jet de gaz enveloppant.

2. Procédé selon la revendication 1, caractérisé en ce que le gaz de propulsion est un gaz inerte.

3. Procédé selon la revendication 2, caractérisé en ce que le gaz inerte est du gaz carbonique ou de l'azote.

4. Procédé selon une des revendications 1 à 3, caractérisé en ce que le gaz de propulsion est mélangé au gaz combustible en une quantité qui établit entre le gaz de propulsion et le mélange gazeux un rapport de 2 à 12% molaire, notamment de 3 à 7% molaire.

5. Procédé selon une des revendications 1 à 4, caractérisé en ce que le gaz enveloppant est un gaz inerte ou de l'air.

6. Procédé selon la revendication 5, caractérisé en ce que le gaz enveloppant est du gaz carbonique ou de l'azote.

7. Procédé selon une des revendications 1 à 6, caractérisé en ce que le jet de gaz enveloppant possède une plus grande vitesse d'écoulement que le gaz combustible ou les gaz de flamme formés lors de la combustion.

8. Procédé selon une des revendications 1 à 7, caractérisé en ce que le jet de gaz enveloppant entoure la flamme de combustion de telle sorte que la section d'écoulement des gaz de flamme soit étranglée.

9. Procédé selon une des revendications 1 à 8, caractérisé en ce qu'on mélange additionnellement au gaz combustible un gaz contenant de l'oxygène non fixé, comme de l'air, de l'air enrichi en oxygène ou de l'oxygène pur.

10. Procédé selon la revendication 9, caractérisé en ce que la proportion d'oxygène dans le mélange formé par le gaz combustible et le gaz contenant de l'oxygène non fixé est comprise entre 1 et 5% molaire.

11. Dispositif à brûleur pour la mise en œuvre du procédé selon une des revendications 1 à 10, caractérisé par un tube à gaz combustible (5) comportant des orifices de sortie 6, par deux tubes à gaz enveloppant (12a, 12b) adjacents au tube à gaz combustible (5) et comportant des orifices de sortie associés (13), les axes des tubes à gaz enveloppant (12a, 12b) et l'axe du tube à gaz combustible étant placés dans un même plan.

12. Dispositif à brûleur selon la revendication 11, caractérisé en ce que les orifices de sortie du tube à gaz combustible sont orientés sensiblement perpendiculairement au plan passant par les axes de tubes.

13. Dispositif à brûleur selon la revendication 12, caractérisé en ce que les orifices de sortie sont disposés dans deux rangées qui sont orientées parallèlement à l'axe des tubes et qui sont placées dans des positions diamétralement opposées.

14. Dispositif à brûleur selon la revendication 11, caractérisé en ce que les orifices de sortie des tubes à gaz enveloppant (12a, 12b) ont la forme d'une fente (13) orientée parallèlement à l'axe de tubes.

## Claims

1. A process for coating surfaces with carbon black, in which an organic, combustible gas is burned and the combustion flame is directed towards the surface which is to be coated, characterised in that, prior to combustion, the gas is mixed with a propelling gas and/or the combustion flame is at least partially surrounded by an enveloping gas jet.

2. A process as claimed in Claim 1, characterised in that the propellant gas is an inert gas.

3. A process as claimed in Claim 2, characterised in that the inert gas is carbon dioxide, or nitrogen.

4. A process as claimed in one of Claims 1 to 3, characterised in that the propellant gas is added to the fuel gas in an amount which gives a propellant gas proportion in the gas mixture of 2 mol-% to 12 mol-%, in particular 3 mol-% to 7 mol-%.

5. A process as claimed in one of Claims 1 to 4, characterised in that the enveloping gas is an inert gas, or air.

6. A process as claimed in Claim 5, characterised in that the enveloping gas is carbon dioxide, or nitrogen.

7. A process as claimed in one of Claims 1 to 6, characterised in that the enveloping gas jet has a higher flow velocity than the fuel gas and the flame gases formed during the combustion.

8. A process as claimed in one of Claims 1 to 8, characterised in that the enveloping gas jet surrounds the combustion flame in such manner that the flow cross-section of the flame gases is constricted.

9. A process as claimed in one of Claims 1 to 8, characterised in that a gas, which contains free oxygen, such as air, oxygen-enriched air, or pure oxygen, is additionally added to the fuel gas.

10. A process as claimed in Claim 9, characterised in that the percentage of oxygen in the mixture consisting of fuel gas and the gas containing free oxygen is from 1 to 5 mol-%.

11. A burner system for carrying out the process as claimed in one of Claims 1 to 10, characterised by a fuel gas pipe (5) having outlet openings (6), and two pipes for enveloping gas (12a, 12b) located adjacent to the fuel gas pipe (5) and having assigned outlet openings (13), the pipe axes of the enveloping gas pipes (12a, 12b) being arranged in one plane with the axis of the fuel gas pipe.

12. A burner system as claimed in Claim 11, characterised in that the outlet openings of the fuel gas pipe are so oriented as to be substantially at right angles to the plane of the pipe axes.

13. A burner system as claimed in Claim 12, characterised in that the outlet openings are arranged in two rows which run parallel to the pipe axis and lie diametrically opposite one another.

14. A burner system as claimed in Claim 11, characterised in that the outlet openings of the enveloping gas pipes (12a, 12b) are in the form of a slot (13) which extends parallel to the pipe axis.

Fig.1

Fig.2

Fig.3